# EUROPÄISCHE PATENTSCHRIFT

(11) **EP 3 478 032 B1**
(45) Veröffentlichungstag und Bekanntmachung des Hinweises auf die Patenterteilung: **01.09.2021**
(21) Anmeldenummer: 17197943.8
(22) Anmeldetag: 24.10.2017
(51) Int. Cl.: H05K 1/02, G01R 27/20

(54) **LEITERPLATTE UND VERWENDUNG EINER KANTENSCHUTZLEISTE**
CIRCUIT BOARD AND USE OF AN EDGE PROTECTION RAIL
CARTE À CIRCUIT IMPRIMÉ ET UTILISATION D'UN RAIL DE PROTECTION D'ARÊTES

(43) Veröffentlichungstag der Anmeldung: 01.05.2019
(73) Patentinhaber: VARTA Microbattery GmbH, 73479 Ellwangen Jagst (DE)
(72) Erfinder: Budjugin, Eugen, 73479 Ellwangen (DE); Kessens, Jochen, 86609 Donauwörth (DE); Kloos, Dieter, 74579 Fichtenau (DE)
(74) Vertreter: Patentanwaltskanzlei Cartagena

(56) Entgegenhaltungen:
- EP-A2- 1 557 736
- DE-A1- 10 340 289
- DE-A1-102007 020 882
- DE-A1-102011 056 890

## Beschreibung

Die nachfolgend beschriebene Erfindung geht aus von einer Leiterplatte mit darauf angeordneten aktiven und/oder passiven elektronischen Bauteilen, die mit Hilfe von auf oder in der Leiterplatte angeordneten Leiterbahnen miteinander und mit einer Spannungsversorgung verbunden sind.

Es ist bekannt, dass derartige Leiterplatten kopiert werden können und dass in Billiglohnländern hergestellte Kopien zu einem wirtschaftlichen Schaden und auch zu Fehlfunktionen von hochwertigen elektrischen Geräten führen können. Zur Verhinderung des einfachen Kopierens derartiger Leiterplatten sind verschiedene Maßnahmen vorgeschlagen worden.

So ist es bekannt, eine Leiterplatte mit einer Schutzvorrichtung gegen Nachbau zu versehen, die ein schichtartiges Schutzelement elektrisch leitfähig zwischen zwei Verdrahtungsleitungen aufweist. Die elektrischen Eigenschaften des Schutzelements werden beim Betrieb der Leiterplatte gemessen. Dieses Schutzelement wird so angeordnet, dass es von außen nicht erkennbar ist. Bei einer einfachen Kopie fehlt das Schutzelement, so dass die Ansteuerung der Leiterplatte erkennen kann, dass es sich um eine Kopie handelt (DE 102010048036 A1).

Aus der DE 102007020882 A1 sind mechanische Verbindungsmittel bekannt, die elektrisch leitfähig ausgebildet sind und in einen elektrischen Stromkreis einbezogen werden um eine Befestigung einer Leiterbahnplatte an einem Träger oder Gehäuse zu kontrolliert bzw. zu überwachen.

Aus der DE 10340289 A1 ist eine Sicherungseinrichtung für eine Leiterplatte bekannt, bei der eine Sicherheitskappe aus Kunststoff in eine Leiterbahn der Leiterplatte integriert ist, so dass ein Eindringversuch in einen Schutzraum, der sich zwischen Leiterplatte und Sicherheitskappe ergibt, erkannt werden kann.

Aus der EP 1557736 A2 ist eine manipulationssichere Leiterplatte bekannt, bei der eine Umhüllung auf eine Oberseite aufgeklebt wird, die um die Kanten der Leiterplatte umgeschlagen wird. In die Ummantelungsind Leiterbahnen eingearbeitet, die über Kontaktpunkte mit entsprechenden Gegenkontakten der Leiterplatte verbunden werden können.

Eine weitere bekannte Lösung zur Ermittlung von unberechtigten Kopien besteht darin, dass eine Steuereinheit während des bestimmungsgemäßen Betriebs des die Leiterplatte aufweisenden Geräts Testvorgänge durchführt und das Ergebnis mit einem Speicherwert innerhalb der Steuereinheit vergleicht. Im Fall einer Nichtübereinstimmung zwischen dem abgespeicherten Ergebnis und dem Testergebnis wird der weitere Betrieb des elektronischen Geräts deaktiviert (DE 102008026276 A1).

Ebenfalls bekannt ist das Anordnen von speziellen Sicherheitsschichten auf beiden Seiten einer Leiterplatte (US 7180008 B2).

Der Erfindung jag die Aufgabe zu Grunde, eine einfach aufgebaute und mit geringem Aufwand zu verwirklichende Möglichkeit des Schutzes von Leiterplatten gegen ein unbefugtes Kopieren zu schaffen.

Zur Lösung dieser Aufgabe schlägt die Erfindung eine Leiterplatte mit den im Anspruch 1 genannten Merkmalen sowie die Verwendung einer Kantenschutzleiste zur Verwirklichung eines Kopierschutzes vor. Weiterbildungen der Erfindung sind Gegenstand von Unteransprüchen.

Es ist üblich, die Kanten von Leiterplatten mit Kantenschutzleisten zu schützen, beispielsweise vor mechanischen Beschädigungen. Darüber hinaus schirmen sie gegebenenfalls auch scharfe Kanten einer Leiterplatte ab. Solche Kantenschutzleisten sind als Meterware erhältlich und weisen meist einen V- oder U-förmigen Querschnitt auf.

Handelsübliche Typen von Kantenschutzleisten weisen häufig einen Zusatz wie beispielsweise Ruß oder Graphit auf, so dass sie in gewissem Ausmaß elektrisch leitend sind. Ihr elektrischer Widerstand kann beispielsweise ca. 10 kΩ/Zentimeter betragen. In der Regel variiert er mit der Temperatur des Materials. Die Zusätze werden als Pigmente oder Füllstoffe zugegeben. Die leitende Eigenschaft solcher Kantenschutzleisten wird bisher nicht ausgenutzt.

Sieht man nun auf der Leiterplatte zwei Kontaktstellen im Bereich einer freien Kante der Leiterplatte vor, so können diese Kontaktstellen durch eine aufgeschobene Kantenschutzleiste einerseits elektrisch leitend miteinander verbunden und andererseits optisch abgedeckt werden, so dass sie nicht mehr sichtbar sind. Eine Schutzeinrichtung kann nun beispielsweise den Widerstand zwischen den beiden Kontaktstellen messen, um auf dieses Weise festzustellen, ob die Kantenschutzleiste vorhanden ist oder nicht. Wenn es vorhanden ist und die Kontaktstellen dadurch miteinander verbunden sind, kann die Leiterplatte in Betrieb gehen. Fehlt eine elektrische Verbindung zwischen den Kontaktstellen, wird die Funktion der Leiterplatte stillgelegt, beispielsweise indem die Funktion mindestens eines elektronischen Bauteils auf der Leiterplatte gestört oder stilllegt wird.

Da die Funktion der beiden Kontaktstellen nicht ohne weiteres ersichtlich ist, besteht die Möglichkeit, dass bei einem Kopiervorgang die unbefugte Kopie der Leiterplatte diese Möglichkeit nicht aufweist. Sie ist damit als Kopie erkennbar.

In Weiterbildung der Erfindung kann vorgesehen sein, dass die Schutzeinrichtung derart ausgebildet ist, dass sie dann, wenn die Verbindung zwischen den beiden Kontaktstellen nicht vorhanden ist, die Stromversorgung der Leiterplatte unterbricht bzw. stilllegt.

Für eine Schutzeinrichtung reicht es aus, wenn zwei Kontaktstellen vorhanden sind. Zur Verbesserung der Erkennung einer unberechtigten Kopie kann jedoch in Weiterbildung der Erfindung auch vorgesehen sein, dass mehr als zwei Kontaktstellen vorhanden sind, wobei für die Erkennung einer Kopie schon das Fehlen derVerbindungzwischen zweien der mehreren Kontaktstellen ausreicht.

In Weiterbildung der Erfindung kann vorgesehen sein, dass jede Kontaktstelle nur auf einer Seite der Leiterplatte angeordnet bzw. ausgebildet ist. Dabei kann vorgesehen sein, dass bei zwei Kontaktstellen diese auf derselben Seite oder aber auf gegenüberliegenden Seiten der Leiterplatte vorhanden sind.

Es ist aber ebenfalls möglich und liegt im Rahmen der Erfindung, dass mindestens eine Kontaktstelle auf beiden Seiten der Leiterplatte angeordnet ist, insbesondere durch diese hindurchgehend.

Besonders sinnvoll ist es, wenn die Leiterplatte in einem elektrischen Gerät verbaut ist und die Kantenschutzleiste und/oder die Kontaktstellen derart angeordnet und/oder ausgebildet sind, dass die Kantenschutzleiste bei unsachgemäßer Öffnung des die Leiterplatte enthaltenden Geräts verrutscht und/oder beschädigt wird und dabei die elektrisch leitende Verbindung zwischen den Kontaktstellen unterbrochen wird.

In einer weiteren möglichen Ausbildung der Erfindung wird vorgeschlagen, dass die Schutzeinrichtung auf der Leiterplatte selbst angeordnet ist.

Die Erfindung schlägt ebenfalls die Verwendung einer mindestens teilweise leitend ausgebildeten Kantenschutzleiste zur Verbindung zweier Kontaktstellen einer Leiterplatte zur Verwirklichung einer Kopierschutzeinrichtung der Leiterplatte vor.

Weitere Merkmale, Einzelheiten und Vorzüge der Erfindung ergeben sich aus den Ansprüchen und der Zusammenfassung, deren beider Wortlaut durch Bezugnahme zum Inhalt der Beschreibung gemacht wird, der folgenden Beschreibung bevorzugter Ausführungsformen der Erfindung sowie anhand der Zeichnung. Hierbei zeigen:
Figur 1 einen Ausschnitt einer als Beispiel dienenden Leiterplatte in Draufsicht;
Figur 2 ein Schaltungsbeispiel zur Verwirklichung einer Schutzeinrichtung als Kopierschutz.

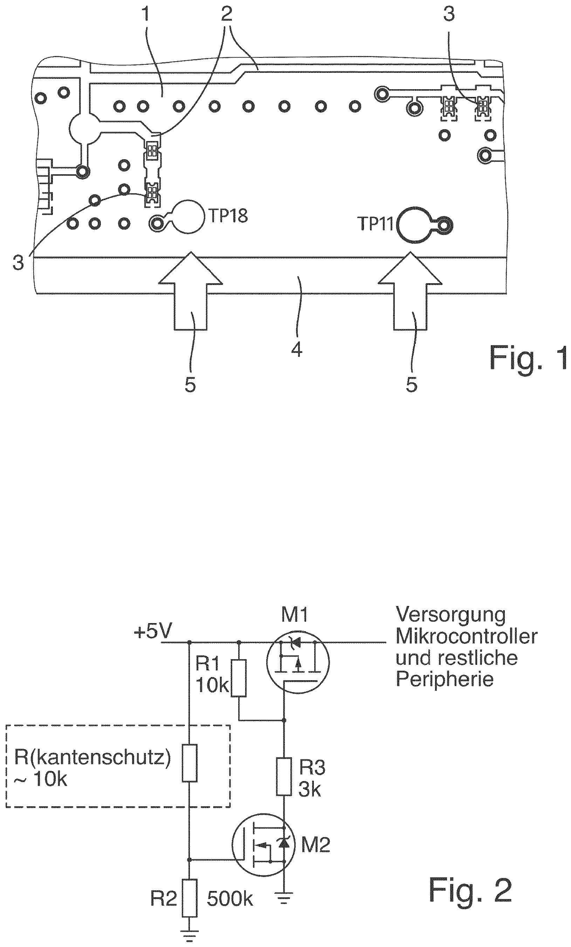

Die Figur 1 zeigt einen Ausschnitt aus einer Leiterplatte in Draufsicht. Die Leiterplatte 1 enthält Leiterbahnen 2, eine Vielzahl von Bauelementen 3, bei denen es sich um Widerstände, Kondensatoren, LEDs, Transistoren und ähnliches handeln kann.

Im Bereich der in Figur 1 unten dargestellten freien Kante 4 sind auf der in Figur 1 zu sehenden Oberseite der Leiterplatte 1 zwei Kontaktstellen TP18 und TP11 ausgebildet, die beide etwa den gleichen Abstand zu der freien Kante 4 der Leiterplatte 1 aufweisen. Auf die beiden Kontaktstellen TP11 und TP18 zeigen die Pfeile 5, die die Ankontaktierung der beiden Kontaktstellen darstellen sollen. Die beiden Kontaktstellen werden von blanken Kupferflächen auf der Platine gebildet und gewährleisten somit einen guten elektrischen Kontakt.

Wird auf die freie Kante 4 der Leiterplatte 1 eine Kantenschutzleiste, die im Querschnitt U-förmig ausgebildet ist, so weit aufgeschoben, dass die Schenkel der U-förmigen Kantenschutzleiste über die beiden Kontaktstellen TP11 und TP18 greifen, so dass diese von einem Betrachter nicht mehr gesehen werden können so entsteht bei Verwendung einer elektrisch leitenden Kantenschutzleiste eine elektrische Verbindung zwischen den beiden Kontaktstellen TP11 und TP18. Der Widerstand zwischen den beiden Kontaktstellen kann mit Hilfe einer Schutzeinrichtung gemessen werden, wobei es nicht auf den exakten Wert des Widerstands ankommt, sondern nur auf die Tatsache, ob eine Verbindung besteht oder nicht. Ein Beispiel für eine derartige Schutzeinrichtung ist in Figur 2 dargestellt.

In Figur 2 ist der durch die zwischen den Punkten TP11 und TP18 aufgeschobene Kantenschutzleiste gebildete Widerstand R_{Kantenschutz} eingezeichnet. Die 5 V-Versorgung für einen auf der Leiterplatte angeordneten Mikrocontroller und die restliche Peripherie kann über einen P-Kanal MOSFET M1 abgeschaltet werden. Ist der Kantenschutz vorhanden, wie in Figur 2 dargestellt, so wirkt der Widerstand des Kantenschutzes als Element eines Spannungsteilers (R2 und R_{Kantenschutz}) und bewirkt dadurch ein Durchschalten des MOSFETs M2. Da der Widerstand des Kantenschutzes von beispielsweise angenähert 10 kΩ wesentlich niedriger ist als der Widerstand R2, liegt am Gate des MOSFETs M2 die 5 V Eingangsspannung an. Somit schaltet auch der P-Kanal MOSFET M1 durch und gewährleistet die Stromversorgung der Platine.

Wird der Kantenschutz entfernt, so dass keine leitende Verbindung zwischen dem 5 V Eingang und den Widerstand R2 vorhanden ist, ist der P-Kanal MOSFET M1 über den 10 kΩ Widerstand R1 in der Gateleitung immer gesperrt. In diesem Fall ist der N-Kanal MOSFET M2 über den Pulldown Widerstand R 2 gesperrt.

Die in Figur 2 als Beispiel dargestellte Schutzeinrichtung unterbricht also bei Fehlen des Kantenschutzes die Stromversorgung der Bauteile auf der Leiterplatte. Andere Schutzeinrichtungen sind ebenfalls möglich, die das Vorhandensein des Kantenschutzes ermitteln.

Sinnvollerweise wird der Kantenschutz so im Gerät bzw. an der Platine verbaut, dass er beim unsachgemäßen Öffnen des Gerätes dauerhaft verrutscht oder beschädigt wird. Dadurch wird sichergestellt, dass die Platine bzw. das Gerät nicht mehr in Betrieb genommen werden kann.

Der durch die aufgeschobene Kantenschutzleiste verwirklichte Kopierschutz ist nicht nur einfach aufgebaut, sondern auch nicht ohne weiteres zu erkennen, was eine zusätzliche Sicherung darstellt.

## Patentansprüche

1. Leiterplatte (1) mit Leiterbahnen (2) und auf ihr angeordneten, mit den Leiterbahnen (2) verbundenen aktiven und/oder passiven elektronischen Bauteilen (3), mit den Merkmalen
a. Die Leiterplatte weist einen Anschluss für eine Stromversorgung auf,
b. Die Leiterplatte weist mindestens zwei Kontaktstellen (TP11, TP18) auf, die im Bereich einer freien Kante (4) der Leiterplatte mit gegenseitigem Abstand zueinander angeordnet und durch eine elektrisch leitende, auf die freie Kante (4) aufgeschobene Kantenschutzleiste abgedeckt und dabei elektrisch leitend miteinander verbunden sind, und
c. Die Leiterplatte weist eine Schutzeinrichtung auf, die derart ausgebildet ist, dass sie den Verbindungszustand der mindestens zwei Kontaktstellen (TP11, TP18) prüft und bei fehlender Verbindung die Funktion mindestens eines der elektronischen Bauteile der Leiterplatte stört oder stilllegt.

2. Leiterplatte nach Anspruch 1 mit dem zusätzlichen Merkmal
a. Die Schutzeinrichtung ist derart ausgebildet, dass sie bei fehlender elektrischer Verbindung der mindestens zwei Kontaktstellen (TP11, TP18) die Stromversorgung zu dem mindestens einen Bauteil (3) unterbricht.

3. Leiterplatte nach einem derAnsprüche 1 oder 2 mit dem zusätzlichen Merkmal
a. Die Leiterplatte weist mehr als zwei durch die Kantenschutzleiste abgedeckte Kontaktstellen (TP11, TP18) auf.

4. Leiterplatte nach einem der vorhergehenden Ansprüche mit dem zusätzlichen Merkmal
a. Die Kontaktstellen (TP11, TP18) sind nur auf einer Seite der Leiterplatte angeordnet.

5. Leiterplatte nach einem der vorhergehenden Ansprüche mit dem zusätzlichen Merkmal
a. Die Kontaktstellen (TP11, TP18) sind auf unterschiedlichen Seiten der Leiterplatte angeordnet.

6. Leiterplatte nach einem der vorhergehenden Ansprüche mit dem zusätzlichen Merkmal
a. Die Kontaktstellen (TP11, TP18) sind auf derselben Seite der Leiterplatte angeordnet.

7. Leiterplatte nach einem der vorhergehenden Ansprüche mit dem zusätzlichen Merkmal
a. Mindestens eine der Kontaktstellen (TP11, TP18) ist auf beiden Seiten der Leiterplatte du rch diese hindurchgehend vorgesehen.

8. Leiterplatte nach einem der vorhergehenden Ansprüche mit den zusätzlichen Merkmalen
a. Die Leiterplatte ist in einem elektrischen Gerät verbaut.

9. Leiterplatte nach einem der vorhergehenden Ansprüche mit dem zusätzlichen Merkmal
a. Die Schutzeinrichtung ist auf der Leiterplatte selbst angeordnet.

10. Verwendung einer mindestens teilweise leitend ausgebildeten Kantenschutzleiste zur Verbindung zweier Kontaktstellen (TP11, TP18) einer Leiterplatte als Bestandteil einer Kopierschutzeinrichtung.

## Claims

1. Printed circuit board (1) with conductor tracks (2) and active and/or passive electronic components (3) arranged on said printed circuit board and connected to the conductor tracks (2), having the following features
a. the printed circuit board has a terminal for a power supply,
b. the printed circuit board has at least two contact points (TP11, TP18), which are arranged spaced apart from one another in the region of a free edge (4) of the printed circuit board and covered by an electrically conductive edge protection rail that has been pushed onto the free edge (4) and in the process are electrically conductively connected to one another, and
c. the printed circuit board has a protection device, which is designed in such a way that it checks the connection state of the at least two contact points (TP11, TP18) and, in the event of no connection, disrupts or shuts down the function of at least one of the electronic components of the printed circuit board.

2. Printed circuit board according to Claim 1 having the additional feature of
a. the protection device is designed in such a way that, in the event of no electrical connection of the at least two contact points (TP11, TP18), it interrupts the power supply to the at least one component (3).

3. Printed circuit board according to one of Claims 1 or 2 having the additional feature of
a. the printed circuit board has more than two contact points (TP11, TP18) covered by the edge protection rail.

4. Printed circuit board according to one of the preceding claims having the additional feature of
a. the contact points (TP11, TP18) are arranged only on one side of the printed circuit board.

5. Printed circuit board according to one of the preceding claims having the additional feature of
a. the contact points (TP11, TP18) are arranged on different sides of the printed circuit board.

6. Printed circuit board according to one of the preceding claims having the additional feature of
a. the contact points (TP11, TP18) are arranged on the same side of the printed circuit board.

7. Printed circuit board according to one of the preceding claims having the additional feature of
a. at least one of the contact points (TP11, TP18) is provided on both sides of the printed circuit board so as to pass through it.

8. Printed circuit board according to one of the preceding claims having the additional feature of
a. the printed circuit board is installed in an electrical device.

9. Printed circuit board according to one of the preceding claims having the additional feature of
a. the protection device is arranged on the printed circuit board itself.

10. Use of an edge protection rail of at least partly conductive design for connecting two contact points (TP11, TP18) of a printed circuit board as a component part of a copy protection device.

## Revendications

1. Circuit imprimé (1) comprenant des pistes conductrices (2) ainsi que des composants électroniques (3) actifs et/ou passifs disposés sur celui-ci et reliés aux pistes conductrices (2), ayant les caractéristiques suivantes
a. le circuit imprimé possède un branchement pour une alimentation électrique,
b. le circuit imprimé possède au moins deux points de contact (TP11, TP18), qui sont disposés dans la zone d'un bord libre (4) du circuit imprimé avec un écart mutuel l'un par rapport à l'autre et recouverts par une baguette de protection de bord électriquement conductrice, enfilée sur le bord libre (4), et ainsi reliés de manière électriquement conductrice l'un à l'autre, et
c. le circuit imprimé possède un dispositif de protection qui est configuré de telle sorte qu'il vérifie l'état de liaison des au moins deux points de contact (TP11, TP18) et, en l'absence de liaison, perturbe ou stoppe le fonctionnement d'au moins l'un des composants électroniques du circuit imprimé.

2. Circuit imprimé selon la revendication 1, ayant la caractéristique supplémentaire
a. le dispositif de protection est configuré de telle sorte qu'en cas d'absence de liaison électrique des au moins deux points de contact (TP11, TP18), il interrompt l'alimentation électrique vers l'au moins un composant (3) .

3. Circuit imprimé selon l'une des revendications 1 et 2, ayant la caractéristique supplémentaire
a. le circuit imprimé possède plus de deux points de contact (TP11, TP18) recouverts par la baguette de protection de bord.

4. Circuit imprimé selon l'une des revendications précédentes, ayant la caractéristique supplémentaire
a. les points de contact (TP11, TP18) ne sont disposés que sur un seul côté du circuit imprimé.

5. Circuit imprimé selon l'une des revendications précédentes, ayant la caractéristique supplémentaire
a. les points de contact (TP11, TP18) sont disposés sur des côtés différents du circuit imprimé.

6. Circuit imprimé selon l'une des revendications précédentes, ayant la caractéristique supplémentaire
a. les points de contact (TP11, TP18) sont disposés du même côté du circuit imprimé.

7. Circuit imprimé selon l'une des revendications précédentes, ayant la caractéristique supplémentaire
a. au moins l'un des points de contact (TP11, TP18) est présent sur les deux côtés du circuit imprimé en traversant celui-ci.

8. Circuit imprimé selon l'une des revendications précédentes, ayant la caractéristique supplémentaire
a. le circuit imprimé est installé dans un appareil électrique.

9. Circuit imprimé selon l'une des revendications précédentes, ayant la caractéristique supplémentaire
a. le dispositif de protection est disposé sur le circuit imprimé lui-même.

10. Utilisation d'une baguette de protection de bord au moins partiellement conductrice pour relier deux points de contact (TP11, TP18) d'un circuit imprimé en tant qu'élément constitutif d'un dispositif de protection contre la copie.
